# EUROPÄISCHE PATENTSCHRIFT

(11) **EP 2 211 396 B1**
(45) Veröffentlichungstag und Bekanntmachung des Hinweises auf die Patenterteilung: **14.10.2015**
(21) Anmeldenummer: 09177774.8
(22) Anmeldetag: 02.12.2009
(51) Int. Cl.: G01D 11/24, G01P 1/02, B29C 45/14, H01L 43/04, B29K 705/00

(54) **Verfahren zur Herstellung eines Sensors**
Method for producing a sensor
Procédé de fabrication d'un capteur

(30) Priorität: 27.01.2009 DE 102009000428
(43) Veröffentlichungstag der Anmeldung: 28.07.2010
(73) Patentinhaber: Robert Bosch GmbH, 70442 Stuttgart (DE)
(72) Erfinder: Mueller, Jochen, 71277, Rutesheim-Perouse (DE); Miessner, Ralf, 71634, Ludwigsburg (DE); Gerhaeusser, Martin, 74336, Brackenheim-Stockheim (DE); Geise, Stephan, 59602, Ruethen (DE)

(56) Entgegenhaltungen:
- EP-A1- 1 634 687
- DE-A1- 4 444 716
- DE-A1-102005 043 413
- DE-A1-102006 001 340
- US-A- 4 733 455

## Beschreibung

### Stand der Technik

Die Erfindung geht aus von bekannten Sensoren, welche in der Lage sind, mindestens eine physikalische und/oder chemische Messgröße zu erfassen. Insbesondere kann die vorliegende Erfindung Sensoren betreffen, welche mindestens ein Sensorelement aufweisen, welches feldsensitiv ausgestaltet ist, also mindestens eine Messgröße in Antwort auf ein Feld, beispielsweise ein elektromagnetisches oder magnetisches Feld, generiert. Im Folgenden wird die Erfindung insbesondere unter Bezugnahme auf Drehzahlsensoren beschrieben, wie sie beispielsweise in der Getriebesteuerung von Kraftfahrzeugen eingesetzt werden. Auch andere Einsatzgebiete sind jedoch grundsätzlich möglich.

Drehzahlsensoren, insbesondere Getriebedrehzahlsensoren, sind beispielsweise in "Sensoren im Kraftfahrzeug", Robert Bosch GmbH, 2. Ausgabe, April 2007, Seiten 117 bis 119 beschrieben. Die dort dargestellten Drehzahlsensoren können auch erfindungsgemäß modifiziert werden, so dass für mögliche Einzelheiten auf diese Veröffentlichung verwiesen werden kann. Auch andere Ausgestaltungen sind jedoch grundsätzlich möglich. Getriebedrehzahlsensoren erfassen Wellendrehzahlen insbesondere in Automatikgetrieben. Drehzahlsensoren werden im Allgemeinen auf der Basis von Hall-Sensoren, beispielsweise integrierten Schaltkreisen (im Folgenden Hall-ICs) hergestellt. Hall-ICs für Rad- bzw. Getriebedrehzahlsensoren werden in der Regel von Zulieferern vorverpackt bezogen, beispielsweise in einem PSSO-x-Gehäuse. Bei Raddrehzahlsensoren können beispielsweise die PSSO-x-Gehäuse je nach Sensierrichtung gebogen und mittels Warmverstemmen mit einem Thermoplasthalter verbunden werden. Die Drehzahlsensoren werden dann an Litzen oder Kabel angeschweißt. Dieser Verbund wird nachfolgend mit einem Thermoplast umspritzt. Ein gängiges Thermoplastmaterial ist beispielsweise Polyamid, beispielsweise PA66, insbesondere mit Glasfaseranteil. Bei Drehzahlsensoren für Getriebesteuerungen wird in der Regel ein Verbund aus Hall-IC, einem Thermoplasthalter, einer Polscheibe und einem Magneten in ein Thermoplastgehäuse eingefügt und nachträglich mit einem Epoxidharz ausgegossen. Das Epoxidharz haftet am Thermoplast und den Stanzgittern an und gewährleistet so eine Mediendichtheit. Andere Herstellungsverfahren für Getriebesensoren verwenden beispielsweise Vorbaugruppen, welche beispielsweise einen ASIC, einen Magneten, eine Polscheibe und ein Stanzgitter umfassen. Diese Vorbaugruppe wird in ein Thermoplastgehäuse eingefügt, welches nachträglich mit Epoxidharz ausgegossen wird. Dieser Verguss dient ebenfalls als Medienschutz.

Drehzahlsensoren, insbesondere in der Raddrehzahlsensorik und/oder der Getriebedrehzahlsensorik, sind jedoch in der Praxis in der Regel sehr hohen Betriebsbelastungen ausgesetzt. Diese ergeben sich beispielsweise in der Kraftfahrzeugtechnik durch die extremen Umgebungstemperaturen, welche zwischen -40°C und +150°C schwanken können. Weiterhin ergeben sich aggressive Betriebsbedingungen durch Umgebungsmedien, insbesondere Getriebeöl (Automatic Transmission Fluid, ATF). Weiterhin sind hohe mechanische Beanspruchungen sowie metallischer Abrieb und Partikelbildungen im Getriebe als Umgebungsbelastungen zu verzeichnen. Aus diesen Belastungen ergeben sich hohe Anforderungen insbesondere an die Mediendichtheit oder Medienresistenz der Sensoren. Einfach mit Thermoplast umspritzte Sensoren sind in der Regel nicht mediendicht, da das thermoplastische Material in vielen Fällen nicht oder nur unzureichend an den übrigen Komponenten haftet, beispielsweise Stanzgittern und/oder Kabelisolierungen. In das Sensorgehäuse eindringende Medien, beispielsweise ATF, können jedoch beispielsweise zu einer Korrosion von Bonddrähten und/oder zu Kurzschlüssen führen. Wünschenswert wäre also ein Sensor, welcher beispielsweise als Raddrehzahlsensor und/oder als Getriebedrehzahlsensor einsetzbar ist und welcher eine erhöhte Mediendichtheit aufweist, insbesondere unter Verwendung von vorverpackten Sensorelementen.

Aus der EP 1 634 687 A1 ist ein Verfahren zur Herstellung von Hybridbauteilen bekannt, bei dem ein Elektronikbauteil mit einem niedrigschmelzenden Schmelzkleber umspritzt wird und das so erhaltene Zwischenprodukt in einem weiteren Spritzgussvorgang mit einem spritzgussfähigen Kunststoff umspritzt wird.

Aus der DE 10 2006 001 340 A1 ist die Dichtung eines Sensor mit Stanzgitter bekannt, wobei das Stanzgitter teilweise mit einer Haftbeschichtung versehen wird, um eine Haftung der Umhüllung auf dem Stanzgitter zu verbessern.

Aus der DE 44 44 716 A1 ist eine induktiver Drehzahlgeber bekannt, der ein Gehäuse aus einem ersten Gehäuseteil aus Metall und einem zweiten, in einem Spritzvorgang aus Kunststoff erzeugten Gehäuseteil aufweist.

Aus der US 4 733 455 ist ein Stanzgitter bekannt, dass mit Kunststoffteilen im Spritzgussverfahren oder Transfermoldverfahren umgeben wird.

### Offenbarung der Erfindung

Es wird ein Verfahren zur Herstellung eines Sensors sowie ein Sensor zur Erfassung mindestens einer physikalischen und/oder chemischen Messgröße vorgeschlagen. Der Sensor kann insbesondere unter Verwendung eines erfindungsgemäßen Verfahrens gemäß einer oder mehreren der im Folgenden beschriebenen Ausführungsformen hergestellt sein und/oder herstellbar sein. Dementsprechend kann für mögliche Ausgestaltungen des Sensors auf die Beschreibung des Verfahrens verwiesen werden und umgekehrt. Der Sensor kann insbesondere als Drehzahlsensor ausgestaltet sein, also zur Drehzahlerfassung, und kann insbesondere zum Einsatz in einem Kraftfahrzeug ausgestaltet sein. Dort sind insbesondere Drehzahlsensoren in Form von Getriebedrehzahlsensoren und/oder Raddrehzahlsensoren als mögliche Anwendungsgebiete zu nennen. Besonders bevorzugt ist der Einsatz in Getriebedrehzahlsensoren, da dort, wie oben dargestellt, die Mediendichtheit, insbesondere die Dichtheit gegenüber Getriebeöl (ATF) eine wesentliche Rolle spielt. Alternativ oder zusätzlich sind jedoch auch andere Arten von Messgrößen und/oder andere Arten von Einsatzgebieten denkbar.

Der Sensor dient der Erfassung mindestens einer physikalischen und/oder chemischen Messgröße. Zu diesem Zweck umfasst der Sensor mindestens ein Sensorelement. Wie oben dargestellt, kann es sich bei diesem Sensorelement insbesondere um ein feldsensitives Sensorelement handeln, insbesondere um ein auf ein magnetisches Feld und/oder elektromagnetisches feldsensitives Sensorelement. Insbesondere kann das Sensorelement also mindestens einen Magnetsensor umfassen, beispielsweise einen Hall-Sensor. Auch andere Arten von Sensorelementen sind jedoch alternativ oder zusätzlich einsetzbar.

Der erfindungsgemäße Sensor umfasst mindestens ein Stanzgitter sowie mindestens einen mit dem Stanzgitter verbundenen Halter aus einem Kunststoffmaterial. Das mindestens eine Sensorelement ist mit dem Stanzgitter elektrisch verbunden. Weiterhin umfasst der Sensor mindestens eine das Stanzgitter, den Halter und das Sensorelement zumindest teilweise umgebende, zumindest weitgehend medienresistente und vorzugsweise elektrisch isolierende Umhüllung. Insbesondere kann es sich dabei um eine zumindest teilweise duroplastische Umhüllung handeln und/oder vorzugsweise um eine Epoxidharzumhüllung, also eine Umhüllung, welche vollständig oder teilweise aus Epoxidharz hergestellt ist. Unter einer zumindest weitgehend medienresistenten Umhüllung ist dabei eine Umhüllung zu verstehen, durch welche sich die Funktionseigenschaften der Umhüllung und/oder des Sensors unter Medieneinfluss üblicher Medien, welchen der Sensor ausgesetzt sein kann, zumindest nicht wesentlich verschlechtern. Derartige Medien können beispielsweise synthetische und/oder natürliche Kraftstoffe, Getriebeöl (ATF) und/oder Kombinationen der genannten und/oder anderer Medien umfassen, beispielsweise Medien, welche üblicherweise in Kraftfahrzeugen eingesetzt werden. Die zumindest weitgehend medienresistente Umhüllung wird im Folgenden vereinfacht als "Umhüllung" bezeichnet. Die Umhüllung kann beispielsweise durch ein Transfermold-Verfahren hergestellt werden.

Das erfindungsgemäße Verfahrung zur Herstellung des Sensors umfasst die im Folgenden beschriebenen Verfahrensschritte, welche vorzugsweise, jedoch nicht notwendigerweise in der dargestellten Reihenfolge durchgeführt werden. Auch weitere Verfahrensschritte können umfasst sein. Weiterhin können auch einzelne oder mehrere Verfahrensschritte zeitlich parallel und/oder zeitlich überlappend und/oder wiederholt durchgeführt werden.

In einem ersten Verfahrensschritt des erfindungsgemäßen Verfahrens wird das Stanzgitter mit mindestens einem Kunststoffmaterial umspritzt, wobei mindestens ein mit dem Stanzgitter verbundener Halter entsteht. Weiterhin wird das mindestens eine Sensorelement elektrisch mit dem Stanzgitter verbunden, und das Stanzgitter, der Halter und das Sensorelement werden zumindest teilweise mit einer zumindest weitgehend medienresistenten Umhüllung umgeben, insbesondere einer Epoxidharzumhüllung. Für die Eigenschaften der Umhüllung kann auf die obige Beschreibung verwiesen werden. Für das Aufbringen dieser Umhüllung wird ein Transfermold-Verfahren eingesetzt.

Unter einem Stanzgitter wird im Rahmen der vorliegenden Erfindung ein elektrisch leitfähiges und im Wesentlichen steifes Gebilde verstanden, welches sowohl mechanische Trägerfunktion als auch elektrisch leitende Funktion aufweist. Das Stanzgitter kann somit zumindest teilweise die Funktion von elektrischen Zuleitungen des Sensors übernehmen. Unter einem steifen Element wird dabei ein Element verstanden, welches zumindest unter Einwirkung einer eigenen Gewichtskraft, vorzugsweise auch unter Einwirkung der Gewichtskraft zusätzlicher Komponenten (wie beispielsweise des Halters und des Sensorelements) formstabil bleibt. Beispielsweise kann das Stanzgitter mindestens einen metallischen Werkstoff umfassen, beispielsweise Cu, CuSn6, CuFe2P oder Kombinationen der genannten und/oder anderer Materialien. Das Stanzgitter kann grundsätzlich auf beliebige Weise hergestellt werden, wobei die Herstellung nicht notwendigerweise auf einen Stanzprozess begrenzt ist. So können alternativ oder zusätzlich beispielsweise auch Schneideverfahren, Biegeverfahren, Erodierverfahren oder ähnliche Verfahren oder Kombinationen der genannten und/oder andere Verfahren eingesetzt werden. Das Stanzgitter kann insbesondere eine oder mehrere elektrische Zuleitungen umfassen, welche vorzugsweise elektrisch voneinander isoliert ausgestaltet sind und welche beispielsweise in kontaktierbaren Enden münden.

Unter einem Halter ist im Rahmen der vorliegenden Erfindung mindestens ein im Wesentlichen formstabiles Element zu verstehen, welches eine mechanisch tragende Funktion erfüllen kann. Zu diesem Zweck kann der Halter beispielsweise ein oder mehrere Befestigungselemente umfassen, welche eine Fixierung und/oder Halterung weiterer Elemente ermöglichen. Beispielsweise können diese Befestigungselemente eines oder mehrere der folgenden Elemente umfassen: eine Tasche; eine Vertiefung; einen Haken; eine Aufnahme; eine Schiene. Auch andere Arten von Befestigungselementen sind alternativ oder zusätzlich möglich.

Unter einem Transfermold-Verfahren ist ein dem Fachmann aus anderen technischen Gebieten, insbesondere der Herstellung von Chipgehäusen, bekanntes Verfahren zu verstehen. Bei diesem Verfahren wird ein fließfähiges Material, beispielsweise ein thermisch und/oder auf andere Weise aushärtbares Kunststoffmaterial, insbesondere ein Duroplast, in einer Kammer vorgeheizt, welche üblicherweise auch als Tiegel (englisch pot) bezeichnet wird. Mittels eines Kolbens wird dieses fließfähige Material dann aus dem Tiegel durch Kanäle in Formnester eines ebenfalls beheizten Werkzeuges geleitet. Die Beheizung erfolgt während des Gießprozesses auf eine Temperatur oberhalb des Schmelzpunktes des fließfähigen Materials. In den Formnestern ist das zu umhüllende Werkstück ganz oder teilweise eingelegt, im vorliegenden Fall insbesondere der Halter, das Sensorelement und das Stanzgitter. Das Werkzeug wird geschlossen gehalten, so lange, bis das fließfähige Material, hier das Material der Umhüllung, im Wesentlichen ausgehärtet ist. Anschließend kann das Werkzeug geöffnet werden, und das umhüllte Werkstück kann entnommen werden. Die Umhüllung kann dabei derart aufgebracht werden, dass diese den Halter und das Sensorelement vorzugsweise vollständig umhüllt. Auch das Stanzgitter soll vorzugsweise vollständig umhüllt sein, wobei jedoch Enden des Stanzgitters vorzugsweise frei bleiben sollen, welche aus der Umhüllung herausragen und welche dementsprechend elektrisch kontaktiert und/oder mechanisch gehaltert werden können. Epoxidharze haben sich als besonders geeignet erwiesen, um einerseits die erforderliche Mediendichtheit zu gewährleisten und um andererseits eine gute Haftung der Umhüllung auf den übrigen Komponenten zu bewirken. Grundsätzlich lassen sich jedoch, alternativ oder zusätzlich, auch beispielsweise andere Arten duroplastischer Materialien und/oder andere Arten von Materialien für die Umhüllung einsetzen.

Um die Haftung der Umhüllung zusätzlich zu erhöhen, wird das Stanzgitter zumindest teilweise mit einer Haftbeschichtung versehen. Auch andere Komponenten des zu umhüllenden Aufbaus können entsprechend beschichtet werden. Die Haftbeschichtung soll ausgestaltet sein, um eine Haftung der Umhüllung auf dem Stanzgitter zu verbessern. Die Haftbeschichtung soll einerseits noch eine elektrische Kontaktierung ermöglichen, beispielsweise einen elektrischen Kontakt zwischen dem Stanzgitter und dem Sensorelement innerhalb des Sensors. Auch eine elektrische Kontaktierung von aus der Umhüllung herausragenden Enden des Stanzgitters sollte gewährleistet sein. Dementsprechend ist es bevorzugt, wenn die Haftbeschichtung, zur Gewährleistung der genannten Erfordernisse, eine oder mehrere der folgenden Beschichtungen umfasst: Silber, insbesondere elektrochemisch erzeugtes Silber (chemisch Ag); Nickel; Gold; Palladium; eine Mehrfachschicht, umfassend Nickel und Gold, insbesondere Ni/Au; eine Mehrfachschicht, umfassend Nickel, Palladium und Gold, insbesondere Ni/Pd/Au; eine metallische Schicht mit mindestens einem organischen Oberflächenschutz, insbesondere Kupfer mit einem organischen Oberflächenschutz. Unter einer Mehrfachschicht ist dabei eine Schichtabfolge zu verstehen, welche vorzugsweise in der genannten Reihenfolge aufgebracht wird. Bei einer Ni/Pd/Au-Mehrfachschicht wird also zunächst eine Nickel-Schicht auf das Stanzgitter aufgebracht, gefolgt von einer Paladium-Schicht, diese wiederum gefolgt von einer Goldschicht. Unter einem organischen Oberflächenschutz (Organic Surface Protection, OSP) ist eine, üblicherweise in der Leiterplattenherstellung, verwendete organische Substanz zu verstehen, welche einerseits die Oberflächen versiegelt und somit beispielsweise einen Korrosionsschutz gewährleistet. Dies ist beispielsweise bei korrodierbaren Metallen, wie zum Beispiel Kupfer, von Bedeutung. Gleichzeitig erhöht eine derartige Oberflächenbeschichtung jedoch die Haftung zusätzlicher Umhüllungen, wie beispielsweise im vorliegenden Fall der Umhüllung, insbesondere aus Epoxidharz. Der organische Oberflächenschutz kann beispielsweise als eine auf substituierten Imidiazolen und/oder Triazolen basierende Lösung und/oder Suspension und/oder Emulsion auf die zu beschichtenden Oberflächen aufgebracht werden.

Weiterhin können die thermomechanischen Eigenschaften der Umhüllung und/oder des Kunststoffmaterials an die Erfordernisse der Mediendichtheit und/oder des Einsatzes innerhalb eines hohen Temperaturbereiches und/oder mit häufigen und harten Thermoschockwechseln angepasst werden. So kann insbesondere die Umhüllung bzw. zumindest ein Material dieser Umhüllung eine Glasübergangstemperatur oberhalb von 140°C, vorzugsweise oberhalb von 150°C, aufweisen. Damit liegt diese Glasübergangstemperatur oberhalb der typischerweise beispielsweise in Kraftfahrzeugen auftretenden Temperaturen. Weiterhin kann die Umhüllung als ganze und/oder mindestens ein Material dieser Umhüllung einen thermischen Ausdehnungskoeffizienten aufweisen, welcher vorzugsweise zwischen 5·10⁻⁶1/K und 30·10⁻⁶ 1/K, insbesondere zwischen 10·10⁻⁶1/K und 20·10⁻⁶ 1/K, liegt. Dies kann insbesondere über einen Temperaturbereich zwischen -50°C und 180°C gegeben sein. Insbesondere zur Erreichung dieser Anforderungen, welche jedoch grundsätzlich auch auf anderem Wege erreichbar sind, ist es bevorzugt, wenn die Umhüllung mindestens ein gefülltes Material, insbesondere ein gefülltes duroplastisches Material, aufweist. So kann die Umhüllung mindestens ein Matrixmaterial, beispielsweise ein duroplastisches Matrixmaterial und/oder ein oder mehrere Epoxidharze, und mindestens ein Füllmaterial zur Verbesserung der thermomechanischen Eigenschaften der Umhüllung aufweisen. Insbesondere kann dieses Füllmaterial eines oder mehrere der folgenden Füllmaterialien umfassen: ein mineralisches Füllmaterial, insbesondere Quarz, insbesondere gemahlenes und/oder umgeschmolzenes Quarz; ein keramisches Füllmaterial; ein Glasfasermaterial. Das Füllmaterial kann beispielsweise in einem Füllgrad zwischen 70 und 95 Massenprozent vorliegen, insbesondere in einem Bereich zwischen 80 und 90 Massenprozent. Um die Haftung der Umhüllung auf dem Stanzgitter zu erhöhen, können alternativ oder zusätzlich weitere Maßnahmen getroffen werden. So kann die Umhüllung beispielsweise mindestens ein Additiv umfassen, welches die Haftung auf dem Stanzgitter verbessert. Derartige Haftvermittler sind beispielsweise insbesondere aus dem Bereich der Kunststofftechnik dem Fachmann bekannt, wobei die dort eingesetzten Haftvermittler beispielsweise auch im Rahmen der vorliegenden Erfindung eingesetzt werden können.

Auch das Kunststoffmaterial, welches zur Herstellung des mindestens einen Halters eingesetzt wird, kann hinsichtlich seiner thermomechanischen Eigenschaften optimiert werden. Das Kunststoffmaterial kann insbesondere ein thermoplastisches Material aufweisen, welches beispielsweise durch ein Spritzgießverfahren auf das Stanzgitter aufgebracht wird. So kann das Stanzgitter beispielsweise zur Erzeugung des Halters mit dem thermoplastischen Material umspritzt werden. Aufgrund der hohen thermomechanischen Anforderungen und der Tatsache, dass thermomechanische Spannungen vorzugsweise soweit wie möglich vermieden werden sollen, haben sich insbesondere eines oder mehrere der folgenden Materialien als vorteilhaft erwiesen: ein Polyethersulfon (PES); ein Polyphenylensulfid (PPS); ein Flüssigkristallpolymer (Liquid Chrystal Polymer, LCP). Da der Halter im Vergleich zum gesamten Sensor vergleichsweise kleinvolumig ausgestaltet werden kann, lassen sich auch teurere, hochwertige Materialien einsetzen, wie beispielsweise das genannte LCP, ohne dass hierdurch die Kosten für die Herstellung des Sensors erheblich erhöht würden. Auch das Kunststoffmaterial kann grundsätzlich als gefülltes Kunststoffmaterial ausgestaltet sein, kann also mindestens ein Matrixmaterial, insbesondere ein thermoplastisches Kunststoff-Matrixmaterial, und mindestens ein Füllmaterial zur Verbesserung der thermomechanischen Eigenschaften des Kunststoffmaterials aufweisen. Insbesondere sind wiederum eines oder mehrere der vorliegenden Füllmaterialien bevorzugt: ein mineralisches Füllmaterial, insbesondere Quarz; ein keramisches Füllmaterial; ein Glasfasermaterial. Typische Füllgrade können beispielsweise zwischen 20% und 60% liegen, insbesondere bei mehr als 30%. Insbesondere durch Einsatz von geeigneten Füllmaterialien, jedoch auch auf andere Weise, kann das Kunststoffmaterial ausgestaltet sein, um über einen Temperaturbereich zwischen -50°C und 180°C einen thermischen Ausdehnungskoeffizienten von weniger als 70·10⁻⁶ 1/K aufzuweisen, insbesondere von weniger als 40·10⁻⁶ 1/K in Fließrichtung und/oder weniger als 60·10⁻⁶ 1/K quer zur Fließrichtung. Diese Eigenschaften können insbesondere wiederum über den Temperaturbereich zwischen -50°C und 180°C vorliegen.

Weiterhin lassen sich zur Vermeidung von Rissen und anderen Beschädigungen die Kanten des Halters zumindest teilweise verrundet und/oder angefast ausgestalten. Beispielsweise lassen sich zur Vermeidung von Rissen in der einen Thermoplasten umschließenden Epoxidharzmasse sämtliche Konturen mit derartigen Verrundungen bzw. Anschrägungen (Fasen) ausführen.

In einem weiteren, optionalen Verfahrensschritt, kann das Sensorelement mit dem Halter verbunden werden. Zu diesem Zweck können beispielsweise ein oder mehrere Befestigungselemente des Halters verwendet werden. Insbesondere können hierzu Warmverstemm-Techniken eingesetzt werden. Auch andere Techniken sind jedoch grundsätzlich alternativ oder zusätzlich einsetzbar.

Weiterhin lassen sich, zusätzlich zu dem mindestens einen Sensorelement, weitere Elemente in den Sensor einbringen. Beispielsweise kann, wie in der oben beschriebenen Veröffentlichung von der Robert Bosch GmbH dargestellt, mindestens ein Magnet vorgesehen sein, welcher beispielsweise als sogenannter rückseitiger Vorspann-Magnet (Back-Bias-Magnet) eingesetzt werden kann. Eine derartige Ausgestaltung ist insbesondere in Verbindung mit ferromagnetischen Triggerrädern bevorzugt. Dieser Magnet kann insbesondere einen oder mehrere Permanentmagnete umfassen. Alternativ oder zusätzlich können weitere Elemente eingebracht werden, beispielsweise ein oder mehrere Homogenisierungsscheiben. Beispielsweise können zwischen den Magneten und das Sensorelement eine oder mehrere Polscheiben eingebracht werden, welche als Homogenisierungsscheiben wirken. Dieses mindestens eine zusätzliche Element, insbesondere der mindestens eine Magnet und/oder die mindestens eine Homogenisierungsscheibe, können insbesondere vor dem Aufbringen der Umhüllung in den Sensor eingebracht werden. Zu diesem Zweck können wiederum ein oder mehrere Befestigungselemente vorgesehen sein, beispielsweise an dem Halter. Beispielsweise kann das mindestens eine zusätzliche Element, beispielsweise der mindestens eine Magnet und/oder die mindestens eine Homogenisierungsscheibe, in mindestens eine entsprechende Tasche des Halters eingebracht werden.

Das vorgeschlagene Verfahren und der vorgeschlagene Sensor weisen gegenüber bekannten Verfahren und Sensoren zahlreiche Vorteile auf. So lässt sich ein äußerst medienresistenter und mediendichter Sensor herstellen, welcher insbesondere in den aggressiven Umgebungen eines Getriebes einsetzbar ist. Weiterhin ist der Sensor innerhalb eines hohen Temperaturbereichs einsetzbar und weitgehend beständig gegenüber Thermoschockwechseln. Im Gegensatz zu herkömmlichen Thermoplast-Umhüllungen lassen sich durch die vorgeschlagenen Umhüllungen, welche durch das Transfermold-Verfahren aufgebracht werden, kleinvolumige, gut haftende Umhüllungen herstellen, insbesondere wenn Epoxidharz-Transfermoldmassen eingesetzt werden. Sämtliche nach außen, das heißt außerhalb der Umhüllung, führende Bestandteile des Stanzgitters können mit einer geeigneten Metallisierung zur Erzielung einer besonderen Haftung der Umhüllung versehen werden. Der innen liegende Halter kann zur Minimierung der mechanischen Spannungen und/oder thermomechanischen Spannungen, wie oben dargestellt, insbesondere aus einem thermoplastischen Material mit angepasstem Ausdehnungskoeffizienten hergestellt werden, insbesondere PES. Insgesamt lässt sich somit ein thermisch stabiles, mediendichtes, kleinvolumiges und kostengünstiges Sensorelement herstellen, welches vielseitig einsetzbar ist, insbesondere im Bereich der Kraftfahrzeugtechnik.

### Kurze Beschreibung der Zeichnungen

Ausführungsbeispiele der Erfindung sind in den Zeichnungen dargestellt und in der nachfolgenden Beschreibung näher erläutert.

Es zeigen
- Figur 1: eine Explosionsdarstellung eines dem Stand der Technik entsprechenden Sensors;
- Figuren 2A bis 2D: Verfahrensschritte eines erfindungsgemäßen Verfahrens zur Herstellung eines Sensors; und
- Figuren 3A und 3B: verschiedene perspektivische Darstellungen eines erfindungsgemäßen Sensors.

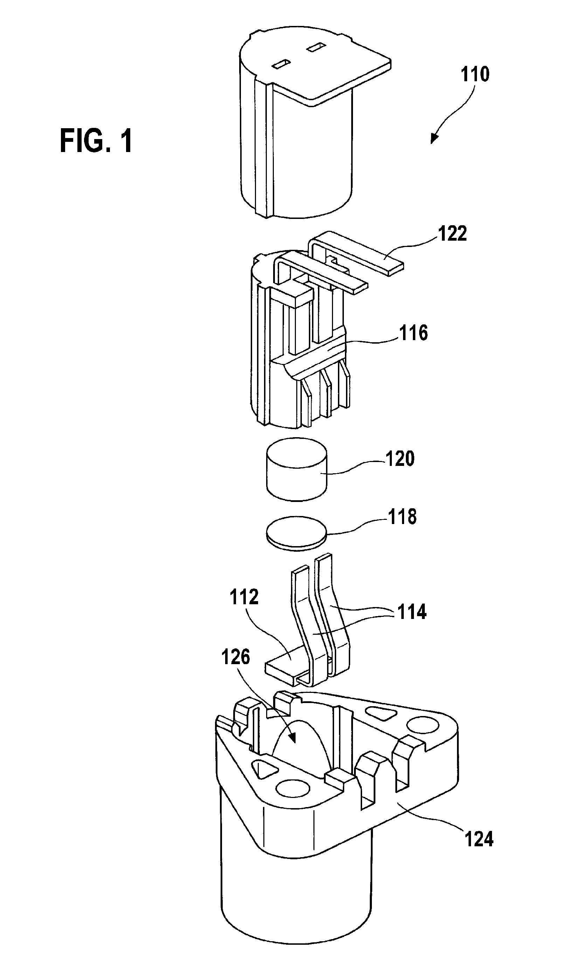

In Figur 1 ist ein dem Stand der Technik entsprechender Sensor 110 in einer Explosionsdarstellung gezeigt. Der Sensor 110 umfasst ein Sensorelement 112, welches im vorliegenden Ausführungsbeispiel als Hall-IC ausgestaltet ist. Beispielsweise kann es sich, wie in der Darstellung gemäß Figur 1, bei diesem Hall-IC um einen Hall-IC in einem PSSO-x-Gehäuse handeln, wobei Anschlusskontakte 114 des Sensorelements 112 entsprechend gebogen werden können. Weiterhin umfasst der Sensor 110 einen Halter 116 aus einem thermoplastischen Material, eine Homogenisierungsscheibe 118 in Form einer Polscheibe und einen Magneten 120. Weiterhin ist ein Stanzgitter 122 vorgesehen, welches von dem thermoplastischen Material des Halters 116 umspritzt ist.

Zur Herstellung des Sensors 110 gemäß dem Stand der Technik in Figur 1 wird das Sensorelement 112 mit dem Halter 116 verbunden, wobei die Anschlusskontakte 114 des Sensorelements 112 elektrisch mit dem Stanzgitter 122 verbunden werden. Anschließend wird ein Verbund aus dem Sensorelement 112, dem Halter 116, dem Magneten 120 und der Homogenisierungsscheibe 118 in einen Hohlraum 126 eines Gehäuses 124 aus einem thermoplastischen Material eingebracht. Anschließend wird dieser Hohlraum 126 mit Epoxidharz ausgegossen. Dieser Verguss dient als Medienschutz der Vorbaugruppe, insbesondere vor ATF.

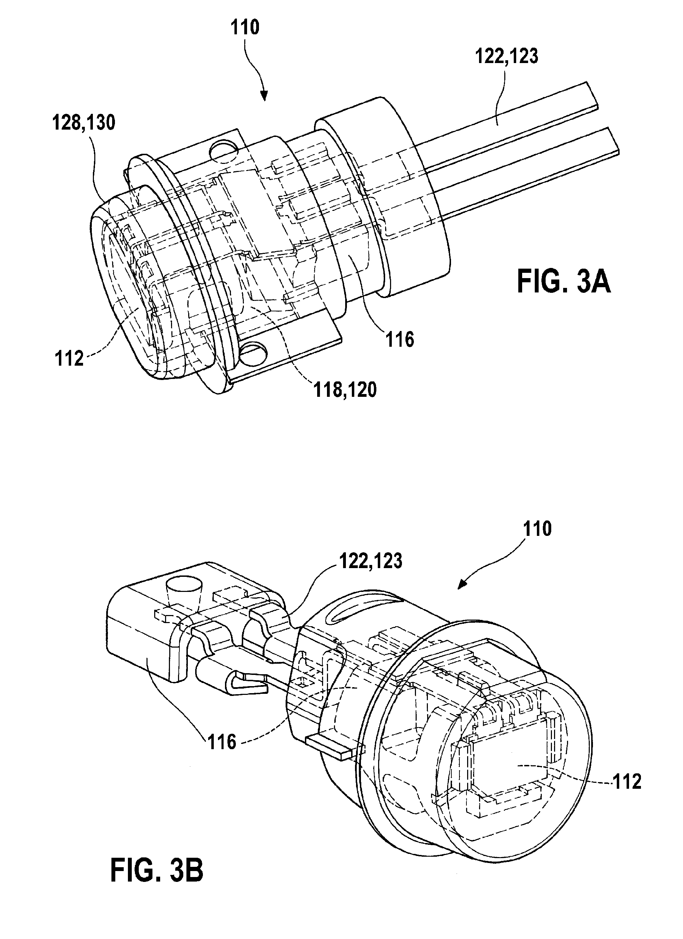

In den Figuren 3A und 3B ist hingegen in verschiedenen perspektivischen Darstellungen ein erfindungsgemäßer Sensor 110 dargestellt. Der Sensor 110 kann beispielsweise als Getriebedrehzahlsensor ausgestaltet sein. Der Sensor umfasst wiederum ein Sensorelement 112, beispielsweise einen Hall-IC, und ein Stanzgitter 122, welches elektrisch leitend mit dem Sensorelement 112 verbunden ist. Weiterhin umfasst der Sensor 110 wiederum einen Halter 116 aus einem thermoplastischen Material, welcher beispielsweise durch Umspritzen des Stanzgitters 122 hergestellt ist. Zusätzlich können wiederum weitere Elemente umfasst sein, beispielsweise mindestens ein Magnet 120 und/oder mindestens eine Homogenisierungsscheibe 118.

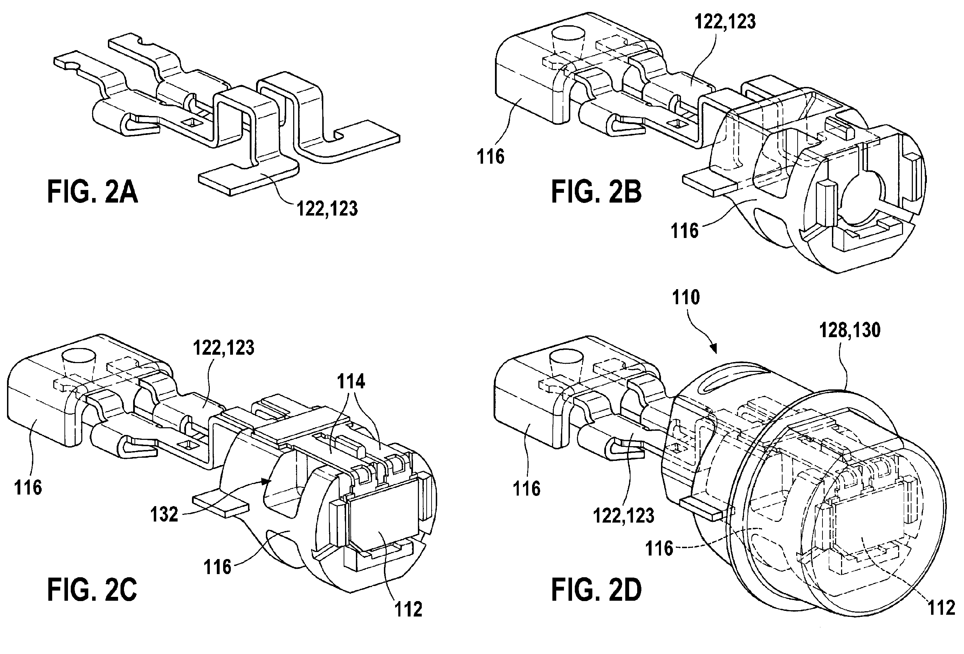

Im Unterschied zu dem Sensor 110 gemäß dem Stand der Technik in Figur 1 umfasst der Sensor 110 gemäß den Figuren 3A und 3B jedoch vorzugsweise kein Gehäuse 124, sondern eine weitgehend medienresistente Umhüllung 128, welche im Folgenden vereinfachend Umhüllung 128 bezeichnet wird und beispielsweise als duroplastische Umhüllung in Form einer Epoxidharz-Transfermoldmasse 130 ausgestaltet ist. Diese Umhüllung 128 umgibt zumindest Teile des Halters 116, des Sensorselements 112 und des Stanzgitters 122. Zur Verbesserung der Haftung der Umhüllung 128 weist das Stanzgitter 122 erfindungsgemäß zumindest teilweise, vorzugsweise zumindest in den Bereichen, in welchen die Umhüllung 128 das Stanzgitter 122 berührt, eine Haftbeschichtung auf, welche in den Figuren symbolisch mit der Bezugsziffer 123 bezeichnet ist. Die Haftbeschichtung 123 wird unten noch anhand von Beispielen näher erläutert. Die Epoxidharz-Transfermoldmasse 130 wird mittels eines Transfermold-Verfahrens aufgebracht, wie nachstehend anhand der Figuren 2A bis 2D näher erläutert wird. Der Sensor 110 umfasst also anstelle eines herkömmlichen Gehäuses 124 ein "Gehäuse" in Form einer Epoxidmasse, die sich durch eine hohe Beständigkeit gegenüber Medien, insbesondere ATF, auszeichnet. Die äußere Formgebung der Umhüllung 128 erfolgt durch den Transfermold-Prozess. Dieser Prozess zeichnet sich durch eine besonders niedrige Belastung hinsichtlich der Temperaturen und der Drücke im Vergleich zu der bei Raddrehzahlsensoren verwendeten Thermoplastumspritzungen aus. Gegenüber vergossenen Sensoren, wie beispielsweise gemäß Figur 1, kann eine kleinere Außengeometrie erreicht werden, da das thermoplastische Gehäuse 124 entfallen kann.

Die Epoxidharz-Transfermoldmasse 130 weist günstige thermomechanische Eigenschaften auf. Insbesondere kann dies eine Glasübergangstemperatur oberhalb der maximalen Anwendungstemperatur von beispielsweise 140°C aufweisen. Weiterhin kann diese einen an das Sensorelement 112, beispielsweise den Hall-IC, und an das Stanzgitter 122 angepassten Ausdehnungskoeffizienten aufweisen, beispielsweise einen Ausdehnungskoeffizienten zwischen 10·10⁻⁶ 1/K und 20·10⁻⁶ 1/K. Zur Erzielung des Ausdehnungskoeffizienten kann die Epoxidharzmasse wie oben beschrieben mit Füllstoffen gefüllt sein. Die Haftung der Epoxidharzmasse auf der Oberfläche der nach außen führenden Stanzgitter 122 kann durch geeignete Additive, insbesondere in Verbindung mit einer adhäsionsfördernden Oberfläche in Form der Haftbeschichtung 123, gezielt erhöht werden.

Der Halter 116 aus thermoplastischem Material kann günstige thermomechanische Eigenschaften aufweisen, insbesondere eine geringe Verarbeitungsschwindung und einen niedrigen Ausdehnungskoeffizienten, beispielsweise weniger als 40·10⁻⁶ 1/K über den Temperaturbereich von -50°C bis 180°C. Besonders gut geeignet sind die thermoplastischen Kunststoffe PES und/oder PPS und/oder LCP, jeweils mit oder ohne Füllung, beispielsweise mineralischer Füllung und/oder Glasfaserfüllung. Vorzugsweise wird PES mit Glasfaserfüllung eingesetzt. Zur Vermeidung von Rissen in der den Thermoplasten des Halters 116 umschließenden Epoxidharzmasse der Umhüllung 128 können sämtliche Konturen mit Verrundungen und/oder Schrägen (Fasen) ausgeführt sein.

Vorverpackte Bauelemente, beispielsweise PSSO-x-Bauelemente gemäß Figur 1, sind üblicherweise nur mit löt- und schweißbaren Oberflächen mit hohem Zinnanteil lieferbar. Diese Oberflächen sind jedoch in der Regel nicht feuchte- und oxidationsstabil, so dass die Haftung von Epoxidharz-Werkstoffen auf diesen Oberflächen nicht oder nur schlecht sichergestellt werden kann. Um dennoch das Eindringen von ATF und/oder anderen Medien in das Innere des Sensors 110 zu verhindern, ist die oben beschriebene Haftbeschichtung 123 vorgesehen. Diese kann vorzugsweise eine Oberfläche mit sehr guter Haftungsausbildung und sehr guter Korrosionsstabilität aufweisen, beispielsweise chemisch Ag, Ni/Au, Ni/Pd/Au, Cu, insbesondere Cu mit organischem Oberflächenschutz (OSP). Gleichzeitig sollten die Oberflächen bzw. die Haftbeschichtung 123 kompatibel zu üblichen Verbindungsverfahren sein, wie beispielsweise Lötverfahren und/oder Schweißverfahren, um die elektrische Kontaktierung des Sensorelements 112 innerhalb der Baugruppe des Sensors 110 zu ermöglichen. Vorzugsweise wird daher als Oberfläche chemisch Ag eingesetzt.

In den Figuren 2A bis 2D sind symbolisch die Verfahrensschritte eines möglichen Ausführungsbeispiels eines erfindungsgemäßen Verfahrens zur Herstellung eines Sensors 110, beispielsweise eines Drehzahlsensors, dargestellt. Ausgangspunkt bildet in Figur 2A ein Stanzgitter 122, welches in diesem Fall zweiteilig ausgebildet ist. Dieses Stanzgitter 122 kann beispielsweise, wie oben dargestellt, ganz oder teilweise mit einer geeigneten Beschichtung versehen sein. In einem in Figur 2B dargestellten Verfahrensschritt wird dieses Stanzgitter 122 teilweise mit einem thermoplastischen Kunststoffmaterial umspritzt, so dass der Halter 116 entsteht. Dieser Halter ist in dem dargestellten Ausführungsbeispiel ebenfalls zweiteilig ausgebildet. Als thermoplastisches Kunststoffmaterial kann beispielsweise PES verwendet werden, beispielsweise mit einer oder mehreren der oben beschriebenen Füllungen.

In einem weiteren, in Figur 2C dargestellten Verfahrensschritt wird das Sensorelement 112, beispielsweise ein zugelieferter Hall-IC, elektrisch mit dem Stanzgitter 122 verbunden. Zu diesem Zweck können die Anschlusskontakte 114 des Sensors 110 beispielsweise mittels üblicher Kontaktierungstechniken, beispielsweise Löten und/oder Schweißen, mit dem Stanzgitter 122 verbunden werden. Zusätzlich kann das Sensorelement 112 noch mit dem thermoplastischen Halter 116 verbunden werden, beispielsweise durch Warmverstemmen. Weiterhin können in dem in Figur 2C dargestellten Verfahrensschritt gegebenenfalls noch zusätzlich der Magnet 120 und/oder die Homogenisierungsscheibe 118 eingebracht werden, beispielsweise in dafür vorgesehene Taschen 132 des Halters 116. Der Magnet 120 und die Homogenisierungsscheibe 118 sind in Figur 2C nicht dargestellt.

Anschließend wird in einem in Figur 2D dargestellten Verfahrensschritt die Umhüllung 128, beispielsweise die Epoxidharzumhüllung, durch Transfermolding hergestellt. Diese Umhüllung 128 überdeckt das Stanzgitter 122 im Bereich des Hall-ICs des Sensorelements 112 vorzugsweise vollständig, so dass nur noch mit einer geeigneten Beschichtung versehene Bereiche des Stanzgitters 122 aus der Umhüllung 128 herausragen. Innerhalb der Umhüllung 128 können dabei auch nicht-haftende Oberflächen des Stanzgitters 122, also Oberflächen ohne Haftbeschichtung 123, vorgesehen sein. Vorzugsweise beginnen jedoch diese nichthaftenden Oberflächen mindestens 1 Millimeter unterhalb der Umhüllung 128, so dass im Grenzbereich der Umhüllung 128, welcher für die Mediendichtigkeit besonders wichtig ist, mit einer guten Haftung zwischen der Umhüllung 128 und dem Stanzgitter 122 ausgestattet sind. Durch diese sehr gute Haftung der Epoxidharz-Transfermoldmasse auf der Oberfläche des Stanzgitters 122 wird das Eindringen von Medien ins Innere des Sensors 110 vorzugsweise vollständig verhindert. Auf diese Weise entsteht ein Sensor, welcher somit insbesondere im Kraftfahrzeugbereich einsetzbar ist, insbesondere in Bereichen, in welchen eine hohe Medienbeständigkeit gewährleistet sein muss. Neben Sensoren für die Getriebesteuerung und/oder Raddrehzahlsensoren sind hierbei auch andere Sensoren mit erhöhter Medienbeständigkeit im Kraftfahrzeugbereich zu nennen, beispielsweise Sensoren für Benzin, Diesel, Batteriesäure oder Ähnliches. Auch eine thermische Beständigkeit kann gewährleistet sein, beispielsweise indem für den Halter 116 thermoplastische Kunststoffmaterialien verwendet werden, welche bezüglich ihres thermischen Ausdehnungskoeffizienten an die Epoxidharz-Transfermoldmasse 130 bzw. ein anderes Material der Umhüllung 128 angepasst sind.

## Patentansprüche

1. Verfahren zur Herstellung eines Sensors (110), insbesondere eines mediendichten Sensors (110), insbesondere zur Drehzahlerfassung, insbesondere zum Einsatz in einem Kraftfahrzeug, wobei mindestens ein Stanzgitter (122) mit einem Kunststoffmaterial umspritzt wird, wobei mindestens ein mit dem Stanzgitter (122) verbundener Halter (116) entsteht, wobei mindestens ein Sensorelement (112), insbesondere ein Magnetsensor, elektrisch mit dem Stanzgitter (122) verbunden wird, wobei weiterhin das Stanzgitter (122), der Halter (116) und das Sensorelement (112) zumindest teilweise mit einer zumindest weitgehend medienresistenten Umhüllung (128) umgeben werden, , wobei eine Epoxidharzumhüllung als Umhüllung (128) und ein Transfermold-Verfahren eingesetzt wird, wobei das Stanzgitter (122) zumindest teilweise mit einer Haftbeschichtung (123) versehen wird, wobei die Haftbeschichtung (123) ausgestaltet ist, um eine Haftung der Umhüllung (128) auf dem Stanzgitter (122) zu verbessern.

2. Verfahren nach dem vorhergehenden Anspruch, wobei die Haftbeschichtung (123) eine oder mehrere der folgenden Beschichtungen umfasst: Silber, insbesondere elektrochemisch erzeugtes Silber; Nickel; Gold; Palladium; eine Mehrfachschicht, umfassend Nickel und Gold, insbesondere Ni/Au; eine Mehrfachschicht, umfassend Nickel, Palladium und Gold, insbesondere Ni/Pd/Au; eine metallische Schicht mit mindestens einem organischen Oberflächenschutz, insbesondere Kupfer mit einem organischen Oberflächenschutz.

3. Verfahren nach einem der vorhergehenden Ansprüche, wobei die Umhüllung (128) eine Glasübergangstemperatur oberhalb von 140°C aufweist.

4. Verfahren nach einem der vorhergehenden Ansprüche, wobei die Umhüllung (128) einen thermischen Ausdehnungskoeffizienten zwischen 5·10⁻⁶ 1/K und 30·10⁻⁶ 1/K aufweist, insbesondere zwischen 10·10⁻⁶ 1/K und 20·10⁻⁶ 1/K.

5. Verfahren nach einem der vorhergehenden Ansprüche, wobei das Kunststoffmaterial und/oder der Halter (116) mindestens ein thermoplastisches Material aufweist, insbesondere mindestens eines der folgenden Materialien: ein Polyethersulfon; ein Polyphenylensulfid; ein Flüssigkristallpolymer.

6. Verfahren nach einem der vorhergehenden Ansprüche, wobei das Kunststoffmaterial über einen Temperaturbereich zwischen -50°C und 180°C einen thermischen Ausdehnungskoeffizienten von weniger als 70·10⁻⁶ 1/K aufweist, insbesondere von weniger als 40·10⁻⁶ 1/K.

7. Verfahren nach einem der vorhergehenden Ansprüche, wobei das Sensorelement (112) mit dem Halter (116) verbunden wird, insbesondere durch Warmverstemmen.

8. Verfahren nach einem der vorhergehenden Ansprüche, wobei die Kanten des Halters (116) zumindest teilweise verrundet und/oder angefast sind.

9. Sensor (110) zur Erfassung mindestens einer physikalischen und/oder chemischen Messgröße, insbesondere herstellbar nach einem Verfahren gemäß einem der vorhergehenden Ansprüche, umfassend mindestens ein Stanzgitter (122) sowie mindestens einen mit dem Stanzgitter (122) verbundenen Halter (116) aus einem Kunststoffmaterial, weiterhin umfassend mindestens ein mit dem Stanzgitter (122) elektrisch verbundenes Sensorelement (112), insbesondere einen Magnetsensor, weiterhin umfassend mindestens eine das Stanzgitter (122), den Halter (116) und das Sensorelement (112) zumindest teilweise umgebende Umhüllung (128), wobei die Umhüllung (128) als Epoxidharzumhüllung ausgeführt ist und durch ein Transfermold-Verfahrenhergestellt ist, wobei das Stanzgitter (122) zumindest teilweise mit einer Haftbeschichtung (123) versehen ist, welche eine Haftung der Umhüllung (128) auf dem Stanzgitter (122) verbessert.

## Claims

1. Method for producing a sensor (110), in particular a media-tight sensor (110), in particular for detecting rotational speeds, in particular for use in a motor vehicle, wherein at least one lead frame (122) is encased in a plastic material, resulting in at least one holder (116) connected to the lead frame (122), wherein at least one sensor element (112), in particular a magnetic sensor, is electrically connected to the lead frame (122), wherein furthermore the lead frame (122), the holder (116) and the sensor element (112) are at least partially surrounded with an at least largely media-resistant cover (128), wherein use is made of an epoxy resin cover as cover (128) and of a transfer moulding method, wherein the lead frame (122) is provided at least in part with an adhesive coating (123), wherein the adhesive coating (123) is designed to improve adhesion between the cover (128) and the lead frame (122).

2. Method according to Claim 1, wherein the adhesive coating (123) comprises one or more of the following coatings: silver, in particular electrochemically generated silver; nickel; gold; palladium; a multilayer, comprising nickel and gold, in particular Ni/Au; a multilayer, comprising nickel, palladium and gold, in particular Ni/Pd/Au; a metallic layer having at least one organic surface protection, in particular copper with an organic surface protection.

3. Method according to either of the preceding claims, wherein the cover (128) has a glass transition temperature above 140°C.

4. Method according to one of the preceding claims, wherein the cover (128) has a coefficient of thermal expansion between 5×10⁻⁶/K and 30×10⁻⁶/K, in particular between 10×10⁻⁶/K and 20×10⁻⁶/K.

5. Method according to one of the preceding claims, wherein the plastic material and/or the holder (116) has at least one thermoplastic material, in particular at least one of the following materials: a polyethersulfone; a polyphenylene sulfide; a liquid crystal polymer.

6. Method according to one of the preceding claims, wherein the plastic material has, over a temperature range between -50°C and 180°C, the coefficient of thermal expansion of less than 70×10⁻⁶/K, in particular less than 40×10⁻⁶/K.

7. Method according to one of the preceding claims, wherein the sensor element (112) is connected to the holder (116), in particular by hot caulking.

8. Method according to one of the preceding claims, wherein the edges of the holder (116) are at least partially rounded and/or bevelled.

9. Sensor (110) for detecting at least one physical and/or chemical measurement variable, which in particular can be produced according to a method according to one of the preceding claims, comprising at least one lead frame (122) and at least one plastic holder (116) connected to the lead frame (122), further comprising at least one sensor element (112), in particular a magnet sensor, electrically connected to the lead frame (122), further comprising at least one cover (128) which at least partially surrounds the lead frame (122), the holder (116) and the sensor element (112), wherein the cover (128) takes the form of an epoxy resin cover and is produced by means of a transfer moulding method, wherein the lead frame (122) is provided at least in part with an adhesive coating (123) which improves adhesion between the cover (128) and the lead frame (122).

## Revendications

1. Procédé de fabrication d'un capteur (110), en particulier d'un capteur (110) étanche vis-à-vis des fluides, notamment pour la saisie de vitesses de rotation, notamment en vue d'une utilisation dans un véhicule automobile, dans lequel
au moins une grille estampée (122) est englobée dans une matière synthétique, au moins un support (116) relié à la grille estampée (122) étant ainsi formé, au moins un élément de capteur (112), en particulier un capteur magnétique, étant raccordé électriquement à la grille estampée (122),
la grille estampée (122), le support (116) et l'élément de capteur (112) étant au moins en partie entourés par une enveloppe (128) au moins largement résistante aux fluides,
une enveloppe en résine époxy étant utilisée comme enveloppe (128) et un procédé de moulage par transfert étant utilisé,
la grille estampée (122) étant au moins en partie dotée d'un revêtement adhésif (123), le revêtement adhésif (123) étant formé pour améliorer l'adhérence entre l'enveloppe (128) et la grille estampée (122).

2. Procédé selon la revendication précédente, dans lequel le revêtement adhésif (123) comporte un ou plusieurs des revêtement suivants : argent, en particulier argent formé par voie électrochimique ; nickel ; or ; palladium ; une couche stratifiée comprenant du nickel et de l'or, en particulier de Ni/Au ; une couche stratifiée comprenant du nickel, du palladium et de l'or, en particulier de Ni/Pd/Au ; une couche métallique comportant au moins une protection organique de surface, en particulier du cuivre doté d'une protection organique de surface.

3. Procédé selon l'une des revendications précédentes, dans lequel l'enveloppe (128) présente une température de transition vitreuse supérieure à 140°C.

4. Procédé selon l'une des revendications précédentes, dans lequel l'enveloppe (128) présente un coefficient de dilatation thermique compris entre 5.10⁻⁶ 1/K et 30.10⁻⁶ 1/K et en particulier entre 10.10⁻⁶ 1/K et 20.10⁻⁶ 1/K.

5. Procédé selon l'une des revendications précédentes, dans lequel la matière synthétique et/ou le support (116) présentent au moins un matériau thermoplastique, en particulier au moins l'un des matériaux suivants : un polyéthersulfone ; un poly(sulfure de phénylène) ; un polymère à cristaux liquides.

6. Procédé selon l'une des revendications précédentes, dans lequel la matière synthétique présente sur une plage de température comprise entre - 50°C et 180°C un coefficient de dilatation thermique inférieur à 70.10⁻⁶ 1/K et en particulier inférieur à 40.10⁻⁶ 1/K.

7. Procédé selon l'une des revendications précédentes, dans lequel l'élément de capteur (112) est raccordé au support (116) en particulier par sertissage thermique.

8. Procédé selon l'une des revendications précédentes, dans lequel les arêtes du support (116) sont au moins en partie arrondies et/ou chanfreinées.

9. Capteur (110) destiné à saisir au moins une grandeur de mesure physique et/ou chimique, fabriqué en particulier par un procédé selon l'une des revendications précédentes et comportant au moins une grille estampée (122) ainsi qu'au moins un support (116) en matière synthétique relié à la grille estampée (122), en outre au moins un élément de capteur (112) raccordé électriquement à la grille estampée (122), en particulier un capteur magnétique, et en outre au moins une enveloppe (128) qui entoure au moins en partie la grille estampée (122), le support (116) et l'élément de capteur (112),
l'enveloppe (128) étant configurée sous la forme d'une enveloppe en résine époxy et réalisée par un procédé de moulage par transfert,
la grille estampée (122) étant dotée au moins en partie d'un revêtement adhésif (123) qui améliore l'adhérence entre l'enveloppe (128) et la grille estampée (122).
